**Europäisches Patentamt**

**European Patent Office**

**Office européen des brevets**

(11) Veröffentlichungsnummer: **0 095 184**
**A2**

(12) # EUROPÄISCHE PATENTANMELDUNG

(21) Anmeldenummer: **83105128.9**

(22) Anmeldetag: **24.05.83**

(51) Int. Cl.³: **H 01 L 29/91**

(30) Priorität: **25.05.82 DE 3219598**

(43) Veröffentlichungstag der Anmeldung:
**30.11.83** Patentblatt **83/48**

(84) Benannte Vertragsstaaten:
**DE FR GB IT NL**

(71) Anmelder: **SIEMENS AKTIENGESELLSCHAFT**
**Berlin und München Wittelsbacherplatz 2**
**D-8000 München 2(DE)**

(72) Erfinder: **Mitlehner, Heinz, Dr. rer. nat.,Phys.**
**Hohenzollernstrasse 104**
**D-8000 München 40(DE)**

(54) Schottky-Leistungsdiode.

(57) Die Sperrspannung einer Schottky-Leistungsdiode wird unter anderem durch die Krümmung der Raumladungszone (8) unter dem Rand des Schottky-Kontaktes (5) begrenzt. Der Krümmungsradius wird durch eine über der Isolationsschicht (2) angeordnete halbisolierende Schicht (4) vergrößert, die einerseits elektrisch mit dem Schottky-Kontakt (5) verbunden ist und andererseits an lateral entfernten Stellen (6) auf Substratpotential liegt. Damit wird die Raumladungszone (8) aufgeweitet. Die Zwischenschicht kann auch unter dem Schottky-Kontakt (5) liegen und bewirkt dort zusätzlich eine Verbesserung des Schaltverhaltens auf physikalischem Wege.

FIG 1

EP 0 095 184 A2

SIEMENS AKTIENGESELLSCHAFT
Berlin und München

Unser Zeichen
VPA 82 P 1 4 1 2 E

## Schottky-Leistungsdiode

Die Erfindung bezieht sich auf eine Schottky-Leistungsdiode mit einem Halbleitersubstrat, mit einer Isolierschicht auf dem Substrat und einem Schottky-Kontakt,
der das Substrat durch ein in der Isolierschicht angebrachtes Fenster kontaktiert.

Die Sperrspannung einer solchen Schottky-Leistungsdiode,
wie sie z. B. in "Electronics", February 5, 1976, Vol.
49, Nr. 3, Seite 85 bis 89 beschrieben worden ist, wird
unter anderem durch die Verteilung der Feldstärke in der
Raumladungszone unter dem Schottky-Kontakt bestimmt. Besonders kritische Bereiche sind dabei die Randgebiete
unter dem Schottky-Kontakt, da hier bedingt durch die
Geometrie der Schottky-Diode eine starke Krümmung der
Raumladungszone auftreten kann. Damit sind starke Feldstärkeerhöhungen verbunden. Zusätzlich ist zu berücksichtigen, daß eventuell vorhandene Ladungen an der
Grenzfläche zwischen Substrat und Isolierschicht die
Krümmung der Raumladungszone verstärken können.

Die aus den genannten Gründen verursachte Erhöhung der
Feldstärke reduziert deutlich die von der Substratdotierung abhängige zulässige maximale Sperrspannung der
Schottky-Leistungsdiode. Zur Erzielung einer bestimmten
Sperrspannung müßte daher niedriger dotiertes Halbleitermaterial für das Substrat verwendet werden, was jedoch einen höheren Durchlaßwiderstand zur Folge hat.

Ein weiteres Problem stellen bei einer Schottky-Leistungsdiode die mit der Krümmung der Raumladungszone an
der Grenzfläche verbundenen Speichereffekte, Leckströme
Hab 1 Dx / 22.04.1982

und Instabilitäten dar. Dabei werden "heiße" Elektronen in die Isolierschicht injiziert und bleiben an den Grenzflächenzuständen haften. Dadurch wird die Ladung der Grenzflächenzustände im Betrieb der Schottky-Leistungsdiode instabil verändert, was wiederum den Verlauf der Raumladungszone beeinflußt.

Der Krümmung der Raumladungszone hat man dadurch entgegenzuwirken versucht, daß der Schottky-Kontakt lateral weit über die Isolierschicht hinausgezogen wurde. Gemäß anderen Vorschlägen wurde durch Strukturierung der Substratoberfläche oder durch zusätzliche eindiffundierte Zonen versucht, die Krümmung der Raumladungszone zu verringern. Bei diesen Lösungen läßt sich jedoch nicht verhindern, daß die Raumladungszone unter dem Rand des Schottky-Kontaktes immer noch eine relativ starke Krümmung aufweist.

Der Erfindung liegt die Aufgabe zugrunde, eine Schottky-Leistungsdiode der eingangs erwähnten Art so weiterzubilden, daß die Raumladungszone vom Schottky-Kontakt lateral nach außen einen nur ganz schwach gekrümmten Verlauf nimmt.

Die Erfindung ist gekennzeichnet durch eine auf der Isolierschicht angeordnete halbisolierende Schicht, die einerseits elektrisch mit dem Schottky-Kontakt verbunden ist und an die andererseits in einem lateralen Abstand vom Schottky-Kontakt ein festes Potential anlegbar ist.

Weiterbildungen sind Gegenstand der Unteransprüche.

Die Erfindung wird an Hand zweier Ausführungsbeispiele in Verbindung mit den Figuren näher erläutert, die Schnitte durch diese Ausführungsbeispiele darstellen. Gleiche Teile sind in beiden Figuren mit den gleichen Bezugsziffern versehen.

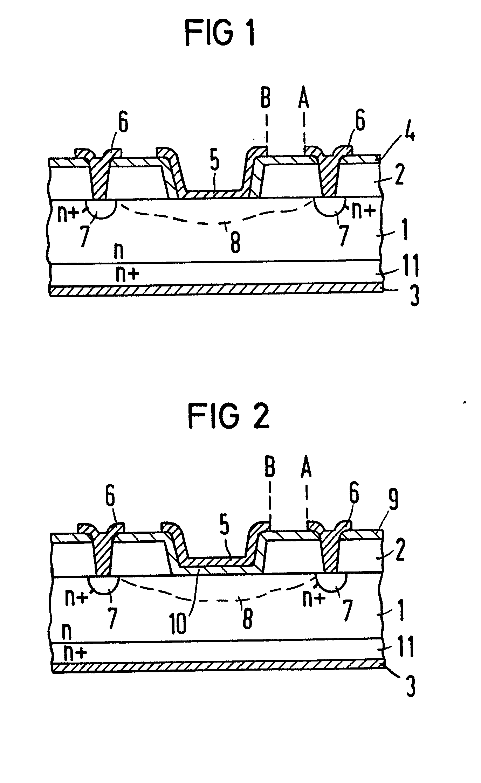

Die Schottky-Leistungsdiode nach Fig. 1 hat ein Substrat 1, das beispielsweise aus n-dotiertem monokristallinem Silicium besteht. Sein spezifischer Widerstand richtet sich nach der geforderten Sperrspannung. Für eine Sperrspannung von ca. 100 V wählt man beispielsweise einen spezifischen Widerstand von 20 Ohm cm und eine Dicke von 50 $\mu$m. Das Substrat ist auf der Oberseite mit einer Isolierschicht 2 bedeckt, die beispielsweise aus Siliciumdioxid $SiO_2$ besteht. Die Unterseite ist mit einem ohmschen Kontakt 3 versehen. Auf der Isolierschicht 2 ist eine halbisolierende Schicht 4 angeordnet. Sie kann einen spezifischen Widerstand zwischen $10^5$ und $10^{11}$ Ohm cm, typischerweise $10^8$ Ohm cm haben. Die Isolierschicht 2 hat ein Fenster, in dem ein Schottky-Kontakt 5 sitzt. Der Schottky-Kontakt 5 aus einem der hierfür üblichen Metalle wie Molybdän, Wolfram usw. steht einerseits im Kontakt mit dem Substrat 1 und ist andererseits mit der halbisolierenden Schicht 4 kontaktiert. In lateralem Abstand vom Schottky-Kontakt 5 ist ein Kontakt 6 vorgesehen, der die halbisolierende Schicht 4 elektrisch über eine in die Oberfläche des Substrats eingebettete z. B. hoch n-dotierte Zone 7 mit dem Substrat verbindet.

Wird nun eine Spannung in Sperrichtung an die Schottky-Leistungsdiode gelegt, so liegt an Punkt A des Kontaktes 6 praktisch das Potential des Substrats an. Am Punkt B liegt dagegen Anodenpotential. Zwischen den Punkten A und B fließt dann entsprechend dem Widerstand der halbisolierenden Schicht 4 ein geringer Strom, der eine vom Kontakt 6 zum Schottky-Kontakt 5 anwachsende Spannung zur Folge hat. Diese Spannung influenziert durch die Isolierschicht 2 an der Oberfläche des Substrats eine Gegenladung, die die Raumladungszone 8 in der dargestellten Weise aufweitet. Es ist ersichtlich, daß die Raumladungszone einen nur sanft gekrümmten Verlauf hat. Dadurch läßt sich ein auf Grund der Krümmung der Raumladungszone verursachter Sperrspannungsdurchbruch vermeiden. Außerdem wirkt diese Schicht als ausgezeichnete Passivierung gegenüber äußeren Ladungen.

Die halbisolierende Schicht 4 kann z. B. aus amorphem oder aus polykristallinem Silicium bestehen. Andere Materialien, wie z. B. amorphes oder polykristallines Germanium, sind ebenfalls möglich. Die Dicke der halbisolierenden Schicht 4 kann zwischen 10 und 50 nm liegen. Die Schicht 4 kann z. B. im Vakuum aufgedampft oder durch Glimmentladung abgeschieden werden. Verfahren zum Aufdampfen und Abscheiden durch Glimmentladung sind in der Fachliteratur bekannt und werden hier nicht besonders behandelt.

Die Schottky-Leistungsdiode nach Fig. 2 unterscheidet sich von der nach Fig. 1 dadurch, daß hier auch unter dem Schottky-Kontakt 5 eine halbisolierende Schicht 10 liegt. Diese kann gleiche Eigenschaften wie die Schicht 9 haben, insbesondere kann sie aus dem gleichen Material bestehen. Auf jeden Fall muß die Schicht 10 die folgenden Bedingungen erfüllen: Die Dichte an Zuständen im verbotenen Band muß zwischen $10^{17}$ und $10^{20}$ eV cm$^{-3}$ liegen, ihre Dicke liegt zwischen 10 und 50 nm und ihr spezifischer Widerstand zwischen $10^5$ und $10^{11}$ Ohm cm, typischerweise $10^8$ Ohm cm. Außerdem muß der Bandabstand des Materials der Schicht 10 größer als der des Substrats sein. Wird für das Substrat 1 monokristallines Silicium verwendet, das einen Bandabstand von 1,1 eV hat, verwendet man für die Schicht 10 amorphes Silicium mit einem Bandabstand von 1,6 eV.

Bei Verwendung einer amorphen Siliciumschicht oder Germaniumschicht genügt dann eine einzige einheitliche Schicht auf der Oberfläche der Isolierschicht 2 und auf Oberfläche des Substrats. Der unter dem Schottky-Kon-

- 5 - VPA 82 P 1412 E

takt 5 liegende Teil 10 der Schicht wirkt so, daß sich ein Teil der Raumladungszone an den Zuständen in der Teilschicht 10 aufbaut. Damit kann bei gleicher maximaler Sperrspannung die Dotierung des Substrats erhöht werden, was einer Verminderung des Durchlaßwiderstandes zugute kommt. Zur Verbesserung des Bahnwiderstandes kann zwischen dem Substrat 1 und dem Kontakt 3 noch eine hochdotierte $n^+$-Zwischenzone 11 liegen.

2 Figuren
8 Patentansprüche

Patentansprüche

1. Schottky-Leistungsdiode mit einem Halbleitersubstrat (1), mit einer Isolierschicht (2) auf dem Substrat und einem Schottky-Kontakt (5), der das Substrat durch ein in der Isolierschicht angebrachtes Fenster kontaktiert, g e k e n n z e i c h n e t durch eine auf der Isolierschicht (2) angeordnete halbisolierende Schicht (4), die einerseits elektrisch mit dem Schottky-Kontakt (5) verbunden ist und an die andererseits in einem lateralen Abstand vom Schottky-Kontakt ein festes Potential anlegbar ist.

2. Schottky-Leistungsdiode nach Anspruch 1, d a - d u r c h  g e k e n n z e i c h n e t , daß an der halbisolierenden Schicht (4) andererseits Substratpotential anliegt.

3. Schottky-Leistungsdiode nach Anspruch 1 oder 2, d a d u r c h  g e k e n n z e i c h n e t , daß die halbisolierende Schicht (4) über einen durch die Isolierschicht (2) reichenden Kontakt (6) elektrisch mit dem Substrat (1) verbunden ist.

4. Schottky-Leistungsdiode nach Anspruch 3, d a - d u r c h  g e k e n n z e i c h n e t , daß der Kontakt (6) mit dem Substrat (1) durch eine in das Substrat eingebettete Hilfszone (7) verbunden ist, die gleichen Leitungstyp, aber höhere Dotierung als das Substrat aufweist.

5. Schottky-Leistungsdiode nach einem der Ansprüche 1 bis 4, d a d u r c h  g e k e n n z e i c h n e t , daß die halbisolierende Schicht (4) einen spezifischen Widerstand zwischen $10^5$ und $10^{11}$ Ohm cm hat.

**0095184**

6. Schottky-Leistungsdiode nach Anspruch 5, d a -
d u r c h   g e k e n n z e i c h n e t ,   daß die
halbisolierende Schicht (9, 10) auch zwischen dem
Schottky-Kontakt (5) und dem Substrat (1) liegt, daß
diese Schicht (9, 10) zumindest zwischen Schottky-Kontakt (5) und Substrat (1) eine Dichte an lokalisierten
Zuständen von $10^{17}$ bis $10^{20}$ eV cm$^{-3}$ hat und daß der
Bandabstand des Materials der halbisolierenden Schicht
(9, 10) zumindest dort größer als der Bandabstand des
Substrats ist.

7. Schottky-Leistungsdiode nach Anspruch 6, d a -
d u r c h   g e k e n n z e i c h n e t ,   daß die
Schicht (9, 10) aus amorphem Silicium und das Substrat
(1) aus monokristallinem Silicium besteht.

8. Schottky-Leistungsdiode nach Anspruch 7, d a -
d u r c h   g e k e n n z e i c h n e t ,   daß die
Schicht (9, 10) zumindest unter dem Schottky-Kontakt eine Dicke zwischen 10 und 50 nm aufweist.

## FIG 1

## FIG 2